# EUROPÄISCHE PATENTANMELDUNG

(11) **EP 0 809 355 A2**
(43) Veröffentlichungstag der Anmeldung: **26.11.1997**
(21) Anmeldenummer: 97108112.0
(22) Anmeldetag: 20.05.1997
(51) Int. Cl.: H03G 3/34

(54) **Verstärkerschaltung**

(30) Priorität: 22.05.1996 DE 19620693
(71) Anmelder: BECKER GmbH, D-76307 Karlsbad (DE)
(72) Erfinder: Smedegaard Pedersen, Michael, 75334 Straubenhardt (DE)
(74) Vertreter: Straub, Bernd

(57) **Zusammenfassung**

Bei einer Verstärkerschaltung mit mehreren Endstufentransistoren (Q1 bis Q4), die im Schalterbetrieb arbeiten, wird im Weg des Stroms (I) durch die Last (L) ein weiterer Transistor (Q5) vorgesehen, der jeweils beim Ein- und Ausschalten des Verstärkers stetig einschaltet bzw. ausschaltet. Auf diese Weise werden abrupte Änderungen des Verstärkerausgangssignals im Augenblick des Ein- oder Ausschaltens vermieden. Die Erfindung eignet sich besonders für NF-Verstärker, die im Schalterbetrieb arbeiten, um Ein- und Ausschaltgeräusche eines angeschlossenen Lautsprechers zu verhindern.

## Beschreibung

Die Erfindung betrifft eine Verstärkerschaltung mit mehreren Endstufentransistoren, die im Schalterbetrieb arbeiten, und insbesondere eine solche Verstärkerschaltung für einen NF-Verstärker.

Verstärkerendstufen, die unstetig im Schalterbetrieb arbeiten, können wesentlich größere Leistungen als in einem stetigen Verstärkerbetrieb verarbeiten. Verstärkt werden dabei Rechteckimpulse, die beispielsweise pulsbreitenmoduliert sind und die erst im Anschluß an die Endverstärkung demoduliert und einer Last zugeführt werden.

Im Augenblick des Ein- oder Ausschaltens eines solchen Verstärkers ändert sich der Stromfluß durch die Last abrupt. Falls die Last ein Lautsprecher ist, entsteht ein mehr oder weniger lauter Ein- bzw. Ausschaltknack.

Der Erfindung liegt die Aufgabe zugrunde, abrupte Änderungen des Ausgangsignals solcher Verstärker beim Ein- oder Ausschalten auf eine einfache und kostengünstige Weise zu vermeiden.

Diese Aufgabe wird gemäß der Erfindung durch die Merkmale des Anspruchs 1 gelöst.

Gemäß der Erfindung genügt ein einziger Transistor, um z.B. Ein- bzw. Ausschaltknacks wirksam zu unterbinden. Dieser Transistor braucht nur eine geringe zulässige Verlustleistung aufzuweisen, da nur während des Ein- und Ausschaltens und auch da nur sehr kurzzeitig Verlustleitung entsteht. Der Transistor läßt sich mit geringem Aufwand stetig ein- oder ausschalten, so daß sich die Kosten zur Ausführung der Erfindung im wesentlichen auf die Kosten eines einzigen Transistors beschränken. Das Vorhandensein dieses Transistors eröffnet außerdem eine Möglichkeit zur Messung bzw. Überwachung des Stroms durch die Lautsprecherspule.

Die Erfindung eignet sich nicht nur für NF-Verstärker mit mehr oder weniger direkt angeschlossenen Lautsprechern, sondern für die verschiedenartigsten Verstärker für Impulssignale, die anschließend in amplitudenanaloge Signale umgeformt werden, sowie die verschiedenartigsten Lasten. Beispielsweise werden die Ein- oder Ausschaltimpulse auch dann wirksam unterdrückt, wenn der Verstärker kein Endverstärker ist, sondern ein analoger Hochleistungsverstärker daran angeschlossen wird. Der hier verwendete Ausdruck "Endstufentransistoren" ist daher so zu verstehen, daß diese Transistoren die letzte Stufe einer Verstärkerschaltung bilden, an die sich auch noch weitere Schaltungen anschließen können.

Weitere Merkmale und Vorteile der Erfindung ergeben sich aus den Unteransprüchen und aus der nachfolgenden Beschreibung eines Ausfürungsbeispiels anhand der Zeichnung. Darin zeigen:
Fig. 1 einen Teil eines NF-Verstärkers mit zwei Endstufentransistoren, die im Schalterbetrieb arbeiten;
Fig. 2 einen Teil eines NF-Verstärkers mit vier Endstufentransistoren, die im Schalterbetrieb arbeiten;
Fig. 3 den Stromverlauf durch den Lautsprecher in Fig. 1 oder 2 beim Ein- und Ausschalten des Verstärkers;
Fig. 4 den NF-Verstärker von Fig. 2 mit einem weiteren Transistor zwischen den Endstufentransistoren und Erde; und
Fig. 5 den Stromverlauf durch den Lautsprecher in Fig. 4 beim Ein- und Ausschalten des Verstärkers.

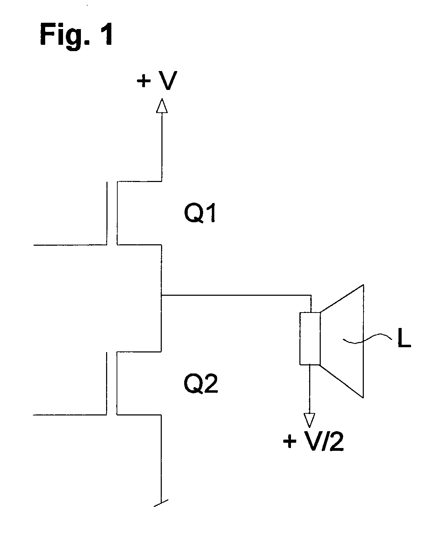

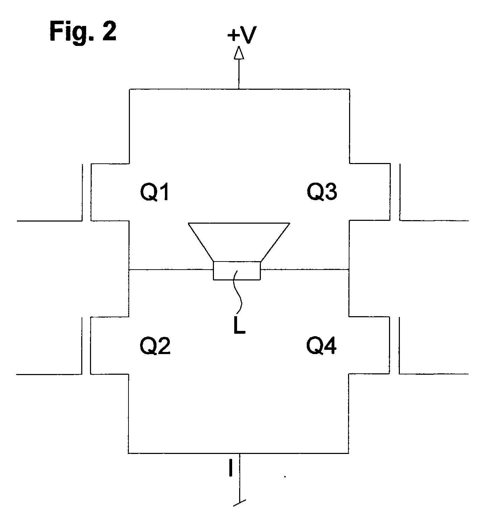

NF-Verstärkerendstufen werden meist als Halbbrückenschaltung, wie in Fig. 1 gezeigt, oder als Vollbrückenschaltung ausgeführt, wie in Fig. 2 gezeigt.

In Fig. 1 sind zwei MOSFET-Transistoren Q1 und Q2 zwischen einer positiven Versorgungsspannung V und Erde hintereinandergeschaltet, und ein Lautsprecher L ist auf einer Seite mit der Source des Transistors Q1 und dem Drain des Transistors Q2 verbunden und auf der anderen Seite mit einer Versorgungsspannung V/2 verbunden.

In Fig. 2 sind vier MOSFET-Transistoren Q1 bis Q4 in einer Brückenschaltung zwischen der positiven Versorgungsspannung V und Erde angeordnet, mit einem quer verbundenen Lautsprecher L als Last.

Die in Fig. 1 oder Fig. 2 gezeigten Endstufentransistoren arbeiten im Schalterbetrieb, d.h. sie befinden sich jeweils entweder im Zustand Ein oder im Zustand Aus, und geben Rechtecksignale aus, die dem Lautsprecher L unmittelbar zugeführt werden. Diese Rechtecksignale weisen eine Folgefrequenz auf, die wesentlich größer ist als die höchste vom Lautsprecher verarbeitbare Frequenz. In diesem Beispiel sind pulsbreitenmodulierte Rechtecksignale vorgesehen, die durch den Lautsprecher selbst demoduliert werden, da der Lautsprecher den Rechtecksignalen nicht unmittelbar folgen kann, sondern sich auf den Mittelwert einer Anzahl von aufeinanderfolgenden Impulsen einstellt, der dem Augenblickswert der Signalamplitude entspricht. Es kann aber auch ein separater Demodulator vorgesehen werden, etwa ein Tiefpaß in der Lautsprecherleitung.

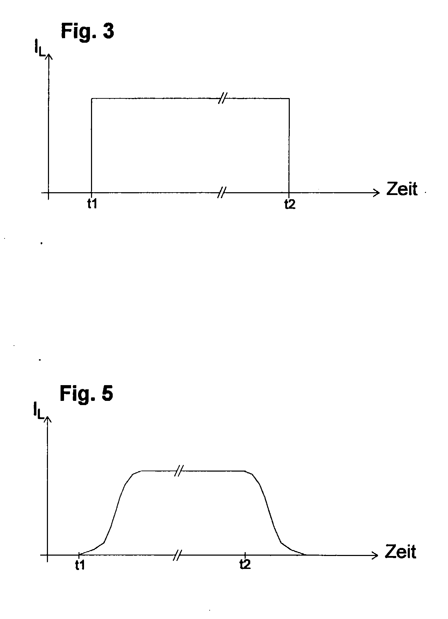

Wenn der in Fig. 1 oder 2 gezeigte Verstärker eingeschaltet wird, indem die Versorgungsspannung V angelegt wird, fließt plötzlich ein Strom I durch die Lautsprecherspule, der dem Augenblickswert der Signalamplitude entspricht. Dies ist in Fig. 3 dargestellt in der der Strom I in einem Einschaltzeitpunkt t1 von Null auf einen Wert ansteigt, der dem Augenblickswert der Signalamplitude entspricht. In Fig. 3 ist die Zeitachse in einer sehr hohen Zeitauflösung dargestellt, so daß der Stromwert als horizontale Linie (wie ein Gleichstrom) erscheint und nachfolgende Änderungen in Übereinstimmung mit dem Augenblickswert der Signalamplitude in dem Diagramm nicht sichtbar sind.

Die Zeitspanne, innerhalb der der Strom I durch die Lautsprecherspule von Null auf den dargestellten konstanten Wert zunimmt, ist zwar nicht Null, wegen der kurzen Schaltzeiten der Transistoren (typischerweise im Bereich von 10 bis 100 ns) jedoch so kurz, daß ein hörbarer "Knack" im Lautsprecher erzeugt wird. Das gleiche geschieht in einem Ausschaltzeitpunkt t2, in dem der Verstärker von der Versorgungsspannung V getrennt wird. Dabei geht der Strom I von irgendeinem Augenblickswert (in Fig. 3 ist der gleiche Wert wie beim Einschalten eingezeichnet) abrupt wieder auf Null zurück.

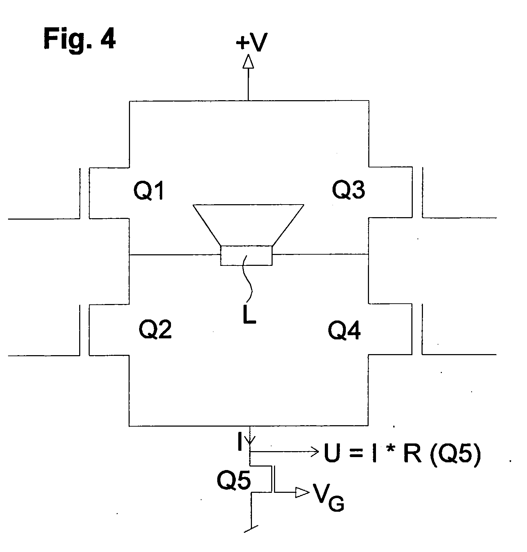

Um die Ein- und Ausschaltknacks zu verhindern, wird bei einer Schaltung wie in Fig. 2 ein weiterer MOSFET-Transistor Q5 in die Leitung zur Erde eingefügt. Wie in Fig. 4 gezeigt, wird die Source des Transistors Q5 mit Erde verbunden, und sein Drain wird mit den Source der Transistoren Q2 und Q4 verbunden.

Die Steuerelektrode bzw. das Gate des Transistors Q5 wird durch eine Steuerspannung V_{G} angesteuert, derart, daß sich beim Ein- und Ausschalten des Verstärkers anstelle des in Fig. 3 dargestellten Stromverlaufs der in Fig. 5 dargestellte Stromverlauf durch die Lautsprecherspule ergibt. Wie in Fig. 5 gezeigt, steigt der Strom I durch die Lautsprecherspule im Zeitpunkt t1 nicht plötzlich, sondern allmählich auf den Augenblickswert der Signalamplitude an, und geht im Zeitpunkt t2 allmählich wieder auf Null zurück. Die Austiegs- und Abfallzeiten des Stroms I durch die Lautsprecherspule werden so gewählt, daß sie größer als die reziproke untere Hörfrequenz sind, d.h. größer als ca. 1/20 Sekunde, so daß der Lautsprecher beim Ein- und Ausschalten des Verstärkers keinerlei hörbares Geräusch erzeugt. Unter Umständen kann es genügen, nur das Schaltgeräusch beim Einschalten oder beim Ausschalten zu unterdrücken.

Der in Fig. 5 gezeigte Stromverlauf ist nicht nur stetig, sondern auch stetig differenzierbar, d.h. ohne irgendeinen "Knick". Dadurch brauchen die Anstiegs- und Abfallzeiten des Stroms I durch die Lautsprecherspule nicht wesentlich größer als ca. 1/20 Sekunde sein, um Ein- und Ausschaltknacks wirksam zu verhindern. Bei genügend langen Anstiegs- und Abfallzeiten kann aber auch irgendein stetiger Verlauf genügen, beispielsweise Anstiegs- und Abfallflanken mit konstanter Steigung.

Die Steuerspannung V_{G} kann beispielsweise einem Kondensator entnommen werden, der über einen Widerstand von der Stromversorgung aufgeladen wird, wenn diese eingeschaltet wird, und beim Abschalten der Stromversorgung wieder entladen wird.

Die Steuerspannung V_{G} kann aber auch mittels einer digitalen Logikschaltung oder eines ohnehin vorhandenen Signalprozessors erzeugt werden, so daß man ohne irgendwelche diskreten Bauelemente auskommt. Auf diese Weise kann man sowohl den Transistor Q5 als auch die Schaltung zur Erzeugung seiner Steuerspannung V_{G} in eine integrierte Schaltung mit aufnehmen, die den Verstärker bildet. Die im Verstärkerbetrieb arbeitenden Endstufentransistoren Q1 bis Q4 und der Transistor Q5 eignen sich wegen ihrer geringen Verlustleistung hervorragend zur Ausführung innerhalb einer integrierten Schaltung. Damit läßt sich ein äußerst kleiner und kompakter Verstärker ohne Ein- und Ausschaltknacks realisieren, der z.B. in einem Lautsprecherchassis untergebracht werden kann, so daß sich ein sehr kompakter Aktivlautsprecher beispielsweise für Automobile ergibt.

Wie in Fig. 5 dargestellt, ist der Transistor Q5 in die Erdleitung des Verstärkers eingefügt, er kann aber auch in die Leitung zur positiven Versorgungsspannung V eingefügt werden. Eine Unterdrückung von Ein- bzw. Ausschaltknacks auf die beschriebene Weise kann auch bei anderen Arten von Endstufenschaltungen als in Fig. 4 gezeigt möglich sein; wesentlich ist, daß sich der weitere Transistor im Stromweg durch den Lautsprecher oder eine andere Last befindet. Bei einer Halbbrückenschaltung wie in Fig. 2 könnte dieser weitere Transistor beispielsweise in einem "Doppeltransistor" in der Verbindungsleitung des Lautsprechers mit der Versorgungsspannung V/2 bestehen, d.h. einem Bauelement, das gleichzeitig in beiden Richtungen gesperrt bzw. leitend gemacht werden kann. Dementsprechend ist der hier verwendete Ausdruck "Transistor" allgemein als ein Bauelement zu verstehen, dessen Leitfähigkeit entweder in einer oder in beiden Richtungen stetig veränderbar ist.

Im Betrieb des Verstärkers entsteht am leitend gemachten Transistor Q5 ein geringer Spannungsabfall U, der dem Strom I durch den Lautsprecher L proportional ist. Dieser Spannungsabfall ist zwar so gering, daß der damit verbundene Leistungsverlust unerheblich ist, kann aber abgefühlt werden, um den Strom I durch den Lautsprecher L laufend zu messen.

Führt man den Spannungsabfall U am Transistor Q5 beispielsweise einem Analog-Digital-Wandler zu, so kann das Ausgangssignal des Analog-Digital-Wandlers von einem Signalprozessor oder einer Logikschaltung verarbeitet werden, um den Strom I durch den Transistor Q5 laufend zu überwachen. Falls der Strom I etwa wegen eines Kurzschlusses am Ausgang einen zulässigen Wert übersteigt, kann der Signalprozessor oder die Logikschaltung den Transistor Q5 äußerst schnell sperren, um die Transistoren Q1 bis Q4 zu schützen, wenn der Signalprozessor oder die Logikschaltung gleichzeitig den Steuerstrom I erzeugt, wie oben beschrieben.

Der Verstärker kann auch noch auf weitere Fehlerstände überwacht werden, beispielsweise Gleichspannungen an den Lautsprecheranschlüssen oder Überhitzungszustände, uni den Transistor Q5 zum Schutz der Transistoren Q1 bis Q4 im Falle eines Fehlers schnell zu sperren.

Die Überwachung des Stroms I und ggf. weiterer Parameter kann zwar auch auf analoge Weise bzw. mit herkömmlichen diskreten Bauelementen durchgeführt werden, eine digitale Überwachungsschaltung hat aber den Vorteil, daß sie ebenso wie die Schaltung zur Erzeugung der Steuerspannung V_{G} leicht in einen Verstärkerbaustein integriert werden kann.

## Patentansprüche

1. Verstärkerschaltung mit mehreren Endstufentransistoren, die im Schalterbetrieb arbeiten, bei welcher der Strom (I) durch die Last (L) einen weiteren Transistor (Q5) durchläuft, der beim Einschalten und/oder Ausschalten des Verstärkers stetig einschaltet bzw. ausschaltet, und bei welcher die Steuerelektrode des weiteren Transistors (Q5) beim Einschalten und/oder Ausschalten des Verstärkers durch die Steuerspannung derart angesteuert wird, daß das Einschalten und/oder Ausschalten des weiteren Transistors (Q5) so langsam stattfindet, daß die Anstiegs- bzw. die Abfallzeiten des Stromes durch die Last größer als die reziproke untere Hörfrequenz sind.

2. Verstärkerschaltung nach Anspruch 1, dadurch gekennzeichnet, daß die Steuerelektrode des weiteren Transistors (Q5) mit einer Steuerschaltung verbunden ist, die mit dem Einschalten des Verstärkers eine Steuerspannung (V_{G}) abgibt, der stetig von Null auf einen Maximalwert zunimmt, und die die Steuerspannung (V_{G}) mit dem Ausschalten des Verstärkers stetig auf Null verringert.

3. Verstärkerschaltung nach Anspruch 1 oder 2, dadurch gekennzeichnet, daß sich die Leitfähigkeit des weiteren Transistors (Q5) beim Einschalten und/oder Ausschalten stetig differenzierbar ändert.

4. Verstärkerschaltung nach einem der vorhergehenden Ansprüche, dadurch gekennzeichnet, daß der weitere Transistor ein MOSFET-Transistor (Q5) ist.

5. Verstärkerschaltung nach einem der vorhergehenden Ansprüche, dadurch gekennzeichnet, daß sie vier Endstufentransistoren (Q1 bis Q4) in Vollbrückenschaltung enthält und daß zwei der Endstufentransistoren (Q2, Q4) über den weiteren Transistor (Q5) mit einem Stromversorgungsanschluß verbunden sind.

6. Verstärkerschaltung nach Anspruch 5, dadurch gekennzeichnet, daß der Stromversorgungsanschluß, mit dem der weitere Transistor (Q5) verbunden ist, die Erde ist.

7. Verstärkerschaltung nach einem der vorhergehenden Ansprüche, dadurch gekennzeichnet, daß der Spannungsabfall (U) an dem weiteren Transistor (Q5) von einer Meß- und/oder Überwachungsschaltung abgefühlt wird.

8. Verstärkerschaltung nach Anspruch 2 und Anspruch 7, dadurch gekennzeichnet, daß der Meßwert des Spannungsabfalls (U) an dem weiteren Transistor (Q5) einer digitalen Schaltung zugeführt wird, die außerdem die Steuerspannung (V_{G}) für diesen Transistor erzeugt.

9. Verstärkerschaltung nach Anspruch 8, dadurch gekennzeichnet, daß sie zusammen mit dem weiteren Transistor (Q5) und der digitalen Schaltung durch eine einzige integrierte Schaltung gebildet wird.
